# EUROPEAN PATENT APPLICATION

(11) **EP 1 193 326 A2**
(43) Date of publication of application: **03.04.2002**
(21) Application number: 01119258.0
(22) Date of filing: 09.08.2001
(51) Int. Cl.: C23C 16/44, H01L 21/00

(54) **Apparatus for reducing particle residues in a semiconductor processing chamber**

(30) Priority: 29.09.2000 US 675990
(71) Applicant: Applied Materials, Inc., Santa Clara, California 95054 (US)
(72) Inventor: Gujer, Rudolf, Saratoga, CA 95070 (US); Cho, Tom K., Palo Alto, CA 94306 (US); Karazim, Michael P., San Jose, California 95123 (US); Ishikawa, Tetsuya, Santa Clara, CA 95050 (US)
(74) Representative: Kirschner, Klaus Dieter, Dipl.-Phys.

(57) **Abstract**

An apparatus for reducing particle residues in a semiconductor wafer processing system comprising a chamber and a chamber slot extending through a sidewall of the chamber. A processing platform having at least one sidewall is coupled to the chamber and a wafer channel extends through the chamber sidewall and the at least one processing platform sidewall such that the wafer channel intersects the chamber slot. A chamber slit valve extends through the chamber slot to control particle residues in the wafer channel.

## Description

The present invention relates generally to apparatus for processing semiconductor wafers. More specifically, the invention relates to an apparatus for reducing residual particle deposits in a processing chamber during a semiconductor wafer process.

Semiconductor processing typically is carried out in specialized apparatus comprised of multiple chambers wherein wafers are processed by the deposition and various treatments of multiple layers of semiconductor material in a single environment. In such apparatus, the plurality of processing chambers and preparatory chambers are arranged in clusters, each served by robotic transfer means. Hence, such apparatus are commonly referred to as cluster tools. Such cluster tools process semiconductor wafers through a plurality of sequential steps to produce integrated circuits.

Regardless of whether semiconductor processing apparatus is configured as described above or in other arrangements known to those skilled in the art, the objective is to process the greatest number of wafers per unit of time. However, it is characteristic of all such apparatus that active chambers, i.e. those wherein semiconductor material is deposited or treated in some other manner such as etching, must periodically be cleaned of the residues inherently formed during such procedures.

One particular concern during the cleaning cycle is that a channel, which is utilized as a substrate entry port to transport the semiconductor wafer from a processing platform to the process chamber, does not receive adequate exposure to the cleaning gases used during a cleaning cycle. Specifically, residual particles from each deposition process may build up in the substrate entry port channel. Flaking of such residual may cause contamination of the substrate wafers during subsequent semiconductor wafer processes. Another concern is maintaining an isolated chamber environment between the processing platform and the chamber. Once the wafer is transported to the deposition chamber, the processing platform has a slit valve that closes off the processing platform. Furthermore, the slit valve comprises an o-ring that seals the channel between the processing platform and the chamber, thereby preventing leakage from the deposition chamber during the deposition and cleaning cycles. After repeated deposition, such residual particles may cause degradation of the o-ring.

Accordingly, there is a need for preventing such residue buildup in the substrate entry port during a deposition process. Furthermore, there is a need to maintain environmental separation of the chambers to ensure that during a semiconductor wafer process or cleaning cycle there is no leakage of either the process gas or cleaning gas respectively. It will further be appreciated that it is desirable to have as high a throughput as possible without sacrifice of the quality of the operation carried out in a deposition chamber before it must be cleaned.

The disadvantages associated with the prior art are overcome by the present invention of semiconductor substrate processing system. Specifically, An apparatus for reducing particle residues in a semiconductor wafer processing system comprising a chamber and a chamber slot extending through a sidewall of the chamber. A processing platform having at least one sidewall is coupled to the chamber and a wafer channel extends through the chamber sidewall and the at least one processing platform sidewall such that the wafer channel intersects the chamber slot. A chamber slit valve extends through the chamber slot to control particle residues in the wafer channel.

The teachings of the present invention can be readily understood by considering the following detailed description in conjunction with the accompanying drawings, in which:
Fig. 1 depicts a partial cross-sectional view of a semiconductor processing system of the present invention; and
FIG. 2 depicts cross-sectional view of a substrate entry port of the embodiment in FIG. 1.

To facilitate understanding, identical reference numerals have been used, where possible, to designate identical element that are common to the figures.

The present invention generally provides an apparatus for processing a semiconductor substrate. The invention is illustratively described below as part of a chemical vapor deposition system, such as an ULTIMA® High Density Plasma Chemical Vapor Deposition (HDP-CVD) chamber, available from Applied Materials, Inc. of Santa Clara, California. However, it should be understood that the invention may be incorporated into other chamber configurations such as physical vapor deposition chambers, etch chambers, ion implant chambers and other semiconductor processing chambers.

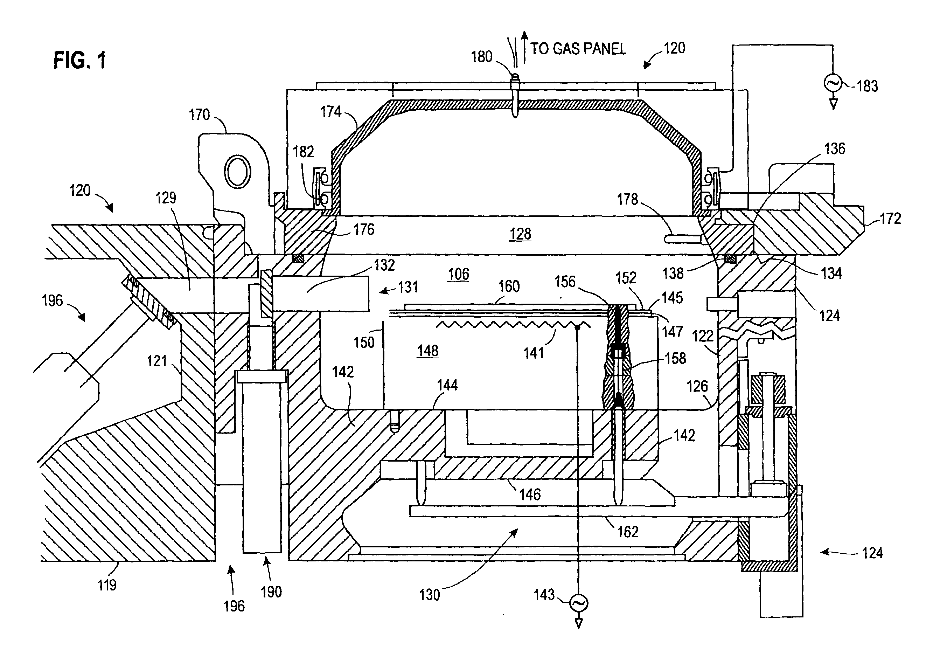

Fig. 1 depicts an illustrative HDP-CVD system (system) 100 that generally comprises a chamber body 102 and a lid assembly 104 that defines an evacuable chamber 106 for carrying out substrate processing. The system 100 may be one a number of substrate processing systems that are coupled to a processing platform 120 such as a CENTURA® processing platform, available from Applied Materials, Inc. Typically, several single-wafer processing chambers are mounted to the processing platform 120, whereby a single wafer is loaded and unloaded through a substrate entry port 132 disposed between each processing chamber 106 and processing platform 120.

The chamber body 102 is typically a unitary, machined structure fabricated from aluminum. The chamber body 102 has a grounded sidewall 122 that in cross section has a substantially rectangular outside surface 124, an annular inner surface 126, and a chamber floor 142 that defines a processing region 128. The processing region 128 generally tapers to define a concentric exhaust passage 130 where process gasses are sent through an exhaust port (not shown) to a rough pump (not shown) for extraction. Furthermore the sidewall 122 of the chamber 102 adjacent to the processing platform 120 comprises a chamber slot 196 for housing a chamber slit valve 190.

The substrate entry port 132 is a channel through one of the sidewalls 122 of the chamber 102. The processing platform 120 also has a platform channel 129 in the same dimension and alignment as the substrate entry port 132 extending through a process platform sidewall 121. Thus, the substrate entry port 132 in conjunction with the platform channel 129, collectively wafer channel 131, provide passage for a wafer between the processing platform 120 and the chamber 102. Furthermore, the substrate entry port 132 intersects the chamber slot 196. In a preferred embodiment, the substrate entry port 132 is positioned horizontally with respect to the chamber floor 142, while the chamber slot 196 is positioned substantially perpendicular to the substrate entry port 132.

A platform slit valve 192 is disposed over the platform channel 129 to allow access through the platform channel 129. In a closed condition, the platform slit valve 192 is extended and covers an end of the platform channel 129. In an open condition, the platform slit valve 192 is retracted from the platform channel 129. Likewise, the chamber slit valve 190, which is housed within the chamber slot 196, selectively extends through the substrate entry port 132 in a closed port condition. Furthermore, the chamber slit valve 190 is retracted from the substrate entry port 132 in a open port condition. A wafer 160 is loaded from the processing platform 120 into the chamber 102 through the wafer channel 131 with the platform and chamber slit valves 192 and 190 in an open position. After the wafer 160 is loaded in the processing chamber 106, the platform and chamber slit valves 192 and 190 are extended to a closed position whereby the processing chamber 106 is sealed from the processing platform 120. In this manner, undesirable semiconductor wafer processing gasses and particle residues are prevented from contacting and accumulating in the substrate entry port 132.

A first surface 134 of the sidewall 122 defines a generally flat landing area on which the lid assembly 104 is supported when in a closed position. An o-ring groove 136 is formed in the first surface 134 of the sidewall 122 to receive an o-ring 138 that forms a gas-tight seal between the chamber body 102 and the lid assembly 104. Typically, the o-ring 138 is fabricated from a fluoropolymer or other material compatible with the processing environment such as CHEMREZ™.

To minimize the generation of particulates caused by interaction of the lid assembly 104 and o-ring 138, a pair of dual pivot hinge assemblies (a first hinge assembly 170 is shown) operably couples the lid assembly 104 to the chamber body 102. The hinge assemblies provide a dual pivot point that seats the lid assembly 104 on the o-ring 138 with minimal shear and abrasion or "pinching" of the o-ring 138. The lid assembly 104 generally includes a lid 172, a dome 174 having a gas distribution ring 176 circumscribing the dome 174. The dome 174 and the gas distribution ring 176 are supported on top of the lid 172. The lid 172 is typically fabricated from aluminum. The dome 174 is made of dielectric material that is transmissive to RF energy, for example, a ceramic such as aluminum oxide (Al₂O₃). A temperature control assembly (not shown) regulates the temperature of the dome 174 during the various process cycles, *i.e.,* deposition cycle and cleaning cycle. Typically, the dome 174 is heated during cleaning cycles and cooled during processing.

The gas distribution ring 176 is disposed between the dome 174 and the chamber body 102. The gas distribution ring 176 typically comprises an annular ring made of aluminum or other suitable material having a plurality of ports formed therein for receiving nozzles 178 that are in communication a gas panel (not shown). The gas panel may alternately be coupled to the chamber 106 via a showerhead or second nozzle 180 disposed above and projecting through the dome 174. Optionally, both the second nozzle 180 and gas distribution ring 176 may be used in conjunction with each other. The gas panel provides process and other gases to the chamber 106. At least one antenna or coil 182 is wound external to the dielectric dome 174. The coil 182 is powered by a variable frequency RF power source 183. The RF power source 183 includes a RF matching network (not shown) to transfer power to plasma generated in the processing region 128.

A substrate support assembly 148 is coupled to the sidewall 122 by one or more support arms 142. Each support arm 142 extends radially between the substrate support assembly 148 and the chamber sidewall 122, positioning the substrate support assembly 148 in the center of the chamber 106. The support arm 142 comprises a first surface 144 for supporting the substrate support assembly 148 and a second surface 146 that faces the exhaust passage 130.

The substrate support assembly 148 may be a heater, a vacuum chuck, or electrostatic chuck on which the substrate or wafer 160 is placed during processing. The substrate support assembly 148 generally comprises a metal body having a heater 141 coupled to a power source 143 embedded therein. An electrostatic chuck 150 comprises a biasing electrode 145 embedded between two dielectric layers 147 such as a polyimide. The electrostatic chuck 122 is disposed on top of the substrate support assembly 148. The biasing electrode 145 is coupled to a biasing power supply (not shown) to create opposing charges between a wafer 160 and the top surface of the electrostatic chuck 150. In this manner, Coulombic forces between the opposing charges thereby retain the wafer 160 to the wafer support surface 152 of the chuck 148 during the semiconductor processing cycle. Additionally, a plurality of lift pins 158 are disposed in corresponding pin bores 156 that extend through the substrate support assembly 148 and electrostatic chuck 150. The lift pins 158 are each coupled at a lower end to a lift pin arm 162 to uniformly lift the wafer 160 off the electrostatic chuck 150 at the end of a wafer process.

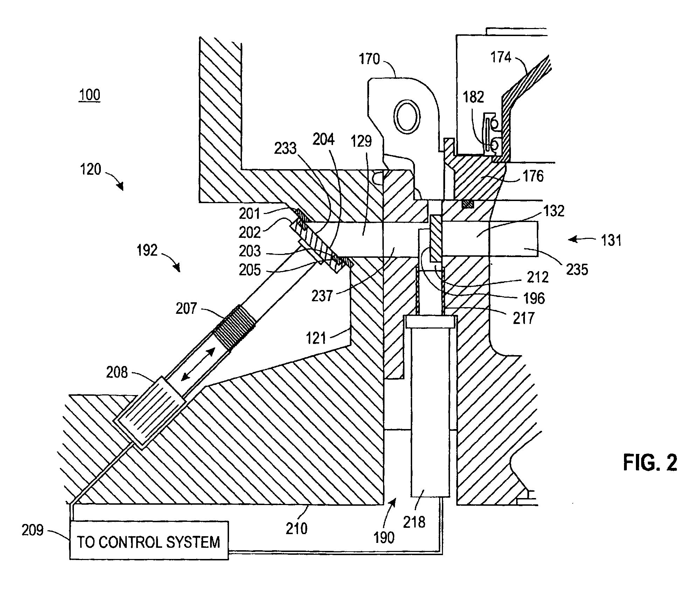

FIG. 2 depicts cross-sectional view of the chamber slit valve 190 of the embodiment in FIG. 1. Loading of the semiconductor wafer 160 begins in the processing platform 120, which is adjacent to the process chamber 102. Specifically, a robotic transfer means (not shown) transfers the wafer 160 in a horizontal orientation with respect to the top surface 152 of the substrate support 148, through the wafer channel 131 and where the wafer 160 is set upon the electrostatic chuck 150 (See FIG.1). In particular, the platform slit valve 192 and chamber slit valve 190 are retracted in an open position to accommodate wafer 160 transportation through the wafer channel 131. The platform slit valve 192 selectively controls access flow through a platform aperture 233 located in the platform sidewall 121 of the processing platform 120. The platform aperture 233 serves as a port for the platform channel 129 portion of the wafer channel 131. The chamber slit valve 192r controls access flow through the substrate entry port 132 portion of the wafer channel 131, proximately between the processing platform 120 and processing chamber 106.

The platform slit valve 192 comprises a platform valve door 202, a platform actuator assembly 208, and a control system 209. The platform actuator assembly 208 may be hydraulic, electric, pneumatic, and the like, and is disposed in a bottom 210 of the processing platform 120. The control'system 209 controls the positions (i.e., open or closed) of the valve door 202 by selectively extending or retracting a platform connecting rod 207 coupled between the platform actuator 208 and valve door 202. Furthermore, one skilled in the art will recognize that the control system 209 may also be a single control system 209 for selectively controlling both platform and chamber slit valves either synchronously or asynchronously.

The platform valve door 202 of the platform slit valve 192 further comprises a valve door face 204 having an o-ring 203 inserted in an o-ring groove 205 therein. The face 204 of the valve door 202 faces a valve seat 201, whereby the valve seat 201 of the platform slit valve 192 is integral with the sidewall 121 of the processing platform 120 and circumscribes the platform aperture 233 of the platform channel 129. The platform slit valve actuator 208 extends and retracts the connecting rod 207 such that the connecting rod 207 maintains a substantially perpendicular position with respect to platform aperture 233. In one embodiment, the actuator 208 of the platform slit valve 192 is anchored at an angle, such as 45 degrees, with respect to the bottom 210 of the processing platform 120. As such, the platform aperture 233 is positioned at an angle to receive the platform valve door face 204 in a closed position. Thus, the of the platform valve door face 204 is parallel to the substrate platform aperture 233 and valve seat 201. Moreover, in an instance where the platform valve slit 290 is in a closed position, the o-ring 203 is compressed against the valve seat 201 without any slippage or sliding with respect to the valve seat 201.

Thus, the configuration of the platform slit valve 192 with respect to the seat valve 291 circumscribing the platform aperture 233 of the platform channel 129, ensures that the valve door ring face o-ring 203 will not be subjected to disfigurement upon closing the valve door 202. Accordingly, leakage of any gasses out of the chamber 106 and into the processing platform 120 via the substrate entry port 132 during the processing or cleaning cycles is avoided. Alternately, in an instance where the platform slit valve 192 is in an open position, the platform aperture 233 of the platform channel 129 is fully exposed to permit the loading or unloading of the wafer 160.

As mentioned previously, the chamber slit valve 190 is disposed between the processing platform 120 and processing chamber 106. In one embodiment, the chamber slit valve 190 is disposed in a chamber slot 196 extending within a chamber sidewall 122. The chamber slot 196 is substantially perpendicular to the substrate entry port 132 and intersects the substrate entry port 132.

The chamber slit valve 192 comprises a chamber valve door 212, a chamber actuator assembly 218, and the control system 209. The chamber actuator assembly 218 may be hydraulic, electric, pneumatic, and the like, and is disposed in a lower portion of the chamber slot 196 of the chamber 102. The control system 209 controls the positions (i.e., open or closed) of the chamber valve door 212 by selectively extending or retracting a chamber connecting rod 217 coupled between the chamber actuator 218 and chamber valve door 212. The chamber valve door 212 has a diameter greater than the diameter of the substrate entry port 132. As such, the valve door 212 of the chamber slit valve 190 slidably extends and retracts through the chamber slot 196 as directed by the control system 209. In an instance where the chamber slit valve 190 is in an open position (along with the platform slit valve 192 being open), an entire length of the wafer channel 131 is available as a channel for loading and unloading the wafer 160. In an instance where the chamber slit valve 190 is in a closed position, a face 214 of the valve door 212 of the chamber slit valve 190 is in contact with a valve seat 211 disposed about the circumference of the chamber slot 196. As such, the chamber valve door face 214 is seated against the valve seat 211 wherein the length of the substrate entry port 132 is divided such that only an external portion 235 of the substrate entry port 132 is exposed to the processing chamber 106. Accordingly, when the valve door 212 of the chamber slit valve 190 is in a closed position, particles are prohibited from depositing on an internal portion 237 of the substrate entry port 132 that is not exposed to the processing chamber 106. In this manner, particle residue is significantly reduced within the confines of the substrate entry port 132 of the wafer channel 131. Furthermore, the o-ring 203 seated in the groove 205 of the platform valve door face 204 is also protected from exposure to particle residues, thus adding longevity to such o-ring 203.

## Claims

1. An apparatus for reducing particle residues during semiconductor wafer processing, comprising:
a chamber;
a chamber slot extending through a sidewall of said chamber;
a substrate entry port extending through said at least one chamber sidewall, said substrate entry port intersecting said chamber slot; and
a chamber slit valve extending through said chamber slot.

2. The apparatus of claim 1, wherein
a processing platform is coupled to said chamber and having at least one sidewall; and wherein
a wafer channel extends through said chamber sidewall and said at least one processing platform sidewall, said wafer channel intersecting said chamber slot.

3. The apparatus of claim 2, wherein said wafer channel is defined by a platform channel aligned with a substrate entry port.

4. The apparatus of claim 3, wherein said substrate entry port intersects said chamber slot.

5. The apparatus of claim 3, wherein said processing platform further comprises a platform slit valve disposed proximate to a platform aperture of said platform channel.

6. The apparatus of claim 5, wherein said platform slit valve comprises a platform valve door that is slidably movable relative to said platform aperture.

7. The apparatus of claim 5, wherein said chamber slit valve door and said platform slit valve door, in closed positions, define an internal portion of said substrate entry port that is not exposed to said particle residues.

8. The apparatus of any of the preceding claims, wherein said chamber slit valve comprises a chamber valve door slidably movable through said chamber slot.

9. The apparatus of claim 8, wherein said chamber slit valve door is extended through said substrate entry port in a closed position; and retracted from said substrate entry port in an open position.

10. The apparatus of claim 9, wherein said chamber slit valve door in said closed position, defines an internal portion of said substrate entry port that is not exposed to said particle residues.

11. The apparatus of any of the preceding claims, wherein said chamber slot extends vertically through said sidewall.

12. The apparatus of any of the preceding claims, wherein said chamber slit valve further comprises a chamber actuator and a chamber valve door coupled via a connecting rod.

13. The apparatus of claim 8, wherein said chamber slot further comprises a chamber valve seat circumscribing said substrate entry port; said chamber valve door further comprises a face, and said chamber slit valve door face is seated in said chamber valve seat in an instance where said chamber valve door is in a closed position.
